# EUROPÄISCHE PATENTSCHRIFT

(11) **EP 0 769 841 B1**
(45) Veröffentlichungstag und Bekanntmachung des Hinweises auf die Patenterteilung: **25.04.2001**
(21) Anmeldenummer: 96107464.8
(22) Anmeldetag: 10.05.1996
(51) Int. Cl.: H02K 37/16, G06M 1/28, G01D 11/24

(54) **Elektromotor und Messwerk, insbesondere für Anzeigeinstrumente in Kraftfahrzeugen**
Electromotor and measuring device, in particular for indicating instrument in vehicle
Moteur électrique et instrument de mesure, en particulier pour indicateurs de véhicules

(30) Priorität: 23.04.1996 DE 19616077; 20.10.1995 DE 19539138
(43) Veröffentlichungstag der Anmeldung: 23.04.1997
(73) Patentinhaber: Mannesmann VDO AG, 60326 Frankfurt (DE)
(72) Erfinder: Kronenberg, Klaus, 65843 Sulzbach (DE); Vorberg, Sabine, 63743 Aschaffenburg (DE); Keutz, Markus, 63480 Rossdorf (DE); Wilhelm, Andreas, 64367 Mühltal (DE); Weiand, Frank, 64289 Darmstadt (DE); Beckhaus, Christian, 64297 Darmstadt (DE); Vorberg, Thomas, 63743 Aschaffenburg (DE); Schmidt, Peter, 61350 Bad Homburg (DE); Blume, Jochem, Dr., 64291 Darmstadt (DE)
(74) Vertreter: Klein, Thomas, Dipl.-Ing. (FH)

(56) Entgegenhaltungen:
- EP-A- 0 116 379
- EP-A- 0 355 264
- EP-A- 0 382 887
- DE-A- 3 145 780
- US-A- 3 978 358
- PATENT ABSTRACTS OF JAPAN vol. 95, no. 11, 26.Dezember 1995 & JP 07 227076 A (YAZAKI CORP), 22.August 1995,
- PATENT ABSTRACTS OF JAPAN vol. 18, no. 515 (E-1611), 28.September 1994 & JP 06 178527 A (SEIKO EPSON CORP), 24.Juni 1994,

## Beschreibung

Die Erfindung betrifft einen Elektromotor nach dem Oberbegriff des Anspruchs 1, welcher zwei voneinander unabhängige Erregerwicklungen auf einem Stator aufweist, mit welchen ein resultierendes Magnetfeld erzeugbar ist sowie einen mindestens ein Polpaar besitzenden, permanent magnetisierten Rotor, welcher seine Position in Abhängigkeit vom Magnetfeld ändert, wobei der Rotor axial auf einer Rotorwelle angeordnet ist sowie ein, diesen Elektromotor enthaltendes Meßwerk für Anzeigeinstrumente.

Elektromotoren mit permanentmagnetischem Rotor sind für viele Anwendungen in einer großen Vielfalt von Bauformen bekanntgeworden. Durch eine Bestromung der Spulen mit Hilfe von elektronischen Schaltungen ist eine vorteilhafte Anwendung von derartigen Motoren für Stell- und Anzeigezwecke möglich. Dabei werden die Elektromotoren häufig als Schrittmotoren betrieben. Solche Motoren sind, zum Beispiel, aus der Patentschrift US-A-3978358 bekannt.

Es ist bekannt, daß Schrittmotoren digitale, elektrische Steuerbefehle in proportionale Winkelschritte umwandeln. Die Rotorwelle des Schrittmotors dreht sich dabei bei jedem Steuerimpuls um einen definierten Schritt weiter.

Bekannte Motoren bestehen aus einem Eisenkreis, auf welchem zwei voneinander unabhängige Erregerwicklungen, die orthogonal gegeneinander gewickelt sind, angeordnet sind. Mit Hilfe dieser Erregerwicklung läßt sich innerhalb des Stators ein Magnetfeld erzeugen, das in seiner räumlichen Lage und Intensität veränderbar ist. Ein Rotor stellt sich abhängig vom Statorfeld jeweils auf die Position des geringsten magnetischen Widerstandes ein. Der Rotor ist auf einer Rotorwelle fest angeordnet, mittels derer die Winkeländerung des Rotors auf ein Zeiger-Antriebssystem zur weiteren Verarbeitung übertragen wird.

Bei dieser beschriebenen Kreuzspulanordung ist eine hohe Symmetrie und Genauigkeit bei der Fertigung der Wicklungen auf dem Eisenkreis notwendig. Außerdem erfordert dieser Aufbau eine mindeste Baugröße des Motors.

Der Erfindung liegt die Aufgabe zugrunde, einen Elektromotor anzugeben, welcher eine geringe Baugröße aufweist sowie leicht herstellbar ist.

Erfindungsgemäß ist die Aufgabe durch das kennzeichnende Merkmal des Anspruchs 1 gelöst.

Der Vorteil der Erfindung besteht darin, daß zwei orthogonal zueinander angeordneten magnetischen Kraftvektoren nicht wie üblich durch die kreuzweise Anordnung der Erregerwicklungen, sondern durch den die Führung des magnetischen Flusses notwendigen Eisenkreis erzeugt wird. Die Form des Eisenkreises hat zur Folge, daß die Erregerwicklungen achsparallel angeordnet sind, was einen kleineren Aufbau des Elektromotors ermöglicht. Auch ist der Elektromotor mit hoher Genauigkeit einfacher herstellbar.

Dabei sind zwei gegenüberliegende Arme des ersten Armpaares einfach zueinander gekröpft, so daß die Arme parallel zueinander ausgerichtet sind, und die zwei gegenüberliegende Arme des zweiten Armpaares mehrfach zueinander gekröpft.

Vorteilhafterweise sind die vier Arme im 90°-Abstand um die Öffnung angeordnet.

Die Arme des zweiten Armpaares weisen in Öffnungsnähe eine erste und in Nähe der freien Enden jedes Armes eine zweite Kröpfung auf.

Der Eisenkreis ist vorteilhafterweise als gefaltetes dreidimensionale Stanz-/Biegeteil ausgeführt.

Eine einfache Montage der Erregerwicklungen ist dadurch möglich, daß der Abstand der Enden der gegeneinander gebogenen Arme der Armpaare so gewählt ist, daß jeweils eine Erregerwicklung magnetisch gekoppelt zwischen diesen lagerbar ist. Jede Erregerwicklung kann beispielweise zwischen die Arme eine Armpaares geklemmt werden. Alternativ dazu können die Enden der gegeneinander gebogenen Arme jedes Armpaares Bohrungen zur Befestigung der Erregerwicklungen aufweisen. Die magnetische Flußkopplung der Erregerwicklung mit dem Eisenkreis des Stators erfolgt durch den Spulenkern der Erregerwicklung.

Aufgrund unterschiedlicher Längen der einzelnen Arme ist es möglich den erfindungsgemäßen Eisenkreis für verschiedene Größen der Erregerwicklungen vorzusehen.

Vorteilhafterweise ist der Rotor in axialer Richtung nicht fluchtend zum Stator angeordnet.

Dadurch kann die geforderte Maßhaltigkeit bzw. das Lagerspiel in axialer Richtung tolerant gehalten werden. Ein federndes Element zur Reduzierung des Axialspieles kann entfallen.

In einer Weiterbildung ist der erfindungsgemäße Elektromotor in einem Meßwerk angeordnet, welcher gemeinsam mit einem Zeigerantriebssystem in einem Gehäuse angeordnet ist. Zwischen Elektromotor und Zeigerantriebssystem ist ein Getriebe zur Übertragung der jeweiligen Rotorposition an das Zeigerantriebssystem zwischen Rotor und einer Zeigerwelle geschaltet, wobei sowohl an der Innenseite des Gehäuses als auch auf einem auf der Zeigerwelle positionierten Stirnrad des Getriebes ein Anschlag zur mechanischen Einstellung des Nullpunktes des Zeigerantriebssystems angeordnet ist.

Durch diese Anordnung ist beim Neustart des Gesamtsystems eine Bestimmung der Winkellage der Zeigerwelle eindeutig möglich. Durch die Winkelbegrenzung durch Anschlag und Gegenanschlag wird auch beim Zusammenbau des Zeigerantriebssystems dafür gesorgt, daß der mechanische Nullpunkt des Zeigers und die Stellung des Rotors in fester Korrelation zueinander stehen.

Dadurch ist eine Einstellung der Nullage der Zeigerwelle mit hoher Genauigkeit möglich.

In einer Ausbildung ist das Gehäuse zylinderförmig gestaltet.

In einer weiteren Ausgestaltung ist zur Befestigung an einem Trägerkörper an mindestens einer kreisförmigen Gehäuseoberfläche des zylinderförmigen Gehäuses mindestens ein Rastzapfen vorgesehen. Der Trägerkörper ist dabei vorteilhafterweise eine Leiterplatte.

Das hat den Vorteil, daß das Meßwerk ohne zusätzliche Elemente durch rastende Zapfen mechanisch an einer Trägerplatte adaptiert.

Auf der entgegengesetzten Gehäuseoberfläche sind ebenfalls Rastzapfen zur Verbindung mit einem Adapter angebracht. Der Adapter weist Öffnungen zur Realisierung einer Schraubverbindung auf.

Die Anbringung eines Adapters an einem Meßwerk ermöglicht eine kostengünstige Erweiterung des Applikationsbereiches. So wird beispielsweise eine Verschraubung mit anderen Bauteilen möglich.

Zur Reduzierung der Teilezahl bei der Herstellung des Meßwerkes ist es vorteilhaft, daß das Gehäuse aus zwei identischen Hälften besteht.

Die Erfindung läßt zahlreiche Ausführungsbeispiele zu. Eines davon soll anhand der in der Zeichnung dargestellten Figuren näher erläutert werden.

Es zeigt
- Fig. 1:: Meßwerk für Zeigersysteme
- Fig. 2:: Anordnung des Antriebs innerhalb des Meßwerkes.
- Fig. 3:: Stator des Schrittmotors
- Fig. 4:: Kontaktierung der Erregerwicklung auf einer Leiterplatte

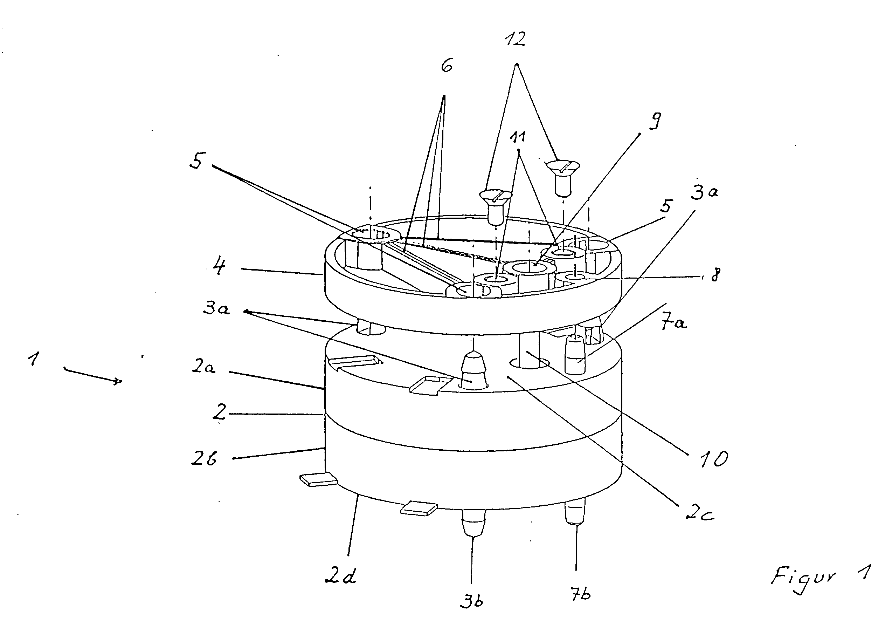

Das in Figur 1 dargestellte Meßwerk 1 ist für den Einsatz in Kombinationsinstrumenten in Kraftfahrzeugen vorgesehen, wo es zur Anzeige von kraftfahrzeugtypischen Daten wie z. B. der Geschwindigkeit oder der Motordrehzahl genutzt wird.

Das Meßwerk 1 besteht aus einem Gehäuse 2, welches aus zwei identischen Hälften 2a und 2b aufgebaut ist. Das Gehäuse 2 ist zylinderfömig gestaltet. Jede Gehäusehälfte 2a bzw. 2b besitzt auf ihrer jeweils kreisförmigen Stirnseite 2c, 2d Rastzapfen 3a, 3b. Die Rastzapfen 3a bzw. 3b sind in 120°-Abständen auf der jeweiligen kreisförmigen Gehäuseoberfläche 2c, 2d der Gehäusehälfte 2a bzw. 2b verteilt. Mit Hilfe der Rastzapfen 3b kann das Gehäuse 2 an einer nicht dargestellten Leiterplatte des Kombinationsinstrumentes befestigt und gleichzeitig arretiert werden.

Zur Realisierung einer Schraubverbindung an dem Gehäuse 2 ist ein Adapter 4 vorgesehen. Die Rastzapfen 3a des Gehäuseteiles 2a greifen in rastende Ausnehmungen 5 des Adapters 4 ein, wodurch eine Schnappverbindung der beiden Bauteile erfolgt. Dabei sind die rastenden Ausnehmungen 5 in den gleichen Abständen von jeweils 120° auf dem ebenfalls einen kreisförmigen Grundriß aufweisenden Adapter 4 verteilt. Die Ausnehmungen 5 stellen dabei das Gegenstück zu den Rastzapfen 3a der Gehäusehälfte 2a dar.

Die Ausnehmungen 5 sind weiter mittels Querverstrebungen 6 gegeneinander stabilisiert.

Jede Gehäusehälfte 2a, 2b weist einen Zentrierungszapfen 7a, 7b auf. Eine Zentrierungsöffnung 8 am Adapter 4, in welche der Zentrierungszapfen 7a der Gehäusehälfte 2a eingreift, gewährleistet, daß das Gehäuse 2 in der richtigen Lage mit dem Adapter 4 verbunden wird. Der Zentrierungszapfen 7b erfüllt diese Funktion gegenüber der nicht dargestellten Leiterplatte.

Der Adapter 4 weist eine durchgängige Öffnung 9 für die aus dem Gehäuse 2 herausgeführte Zeigerwelle 10 auf, an welcher ein nicht weiter dargestellter Zeiger angeordnet ist.

Symmetrisch zu dieser durchgängigen Öffnung 9 befinden sich zwei Windungen 11 zur Aufnahme von Schrauben 12, mittels derer z. B. ein Zifferblatt am Adapter 4 befestigt werden kann. Es ist aber auch denkbar, daß an Stelle der Windungen 11 nur Öffnungen vorhanden sind und das Zifferblatt mit Hilfe von selbstschneidenden Schrauben am Adapter befestigt werden.

Die Zeigerwelle 10 wird durch einen Schrittmotor angetrieben, welcher im Gehäuse 2 des Meßwerkes 1 angeordnet ist.

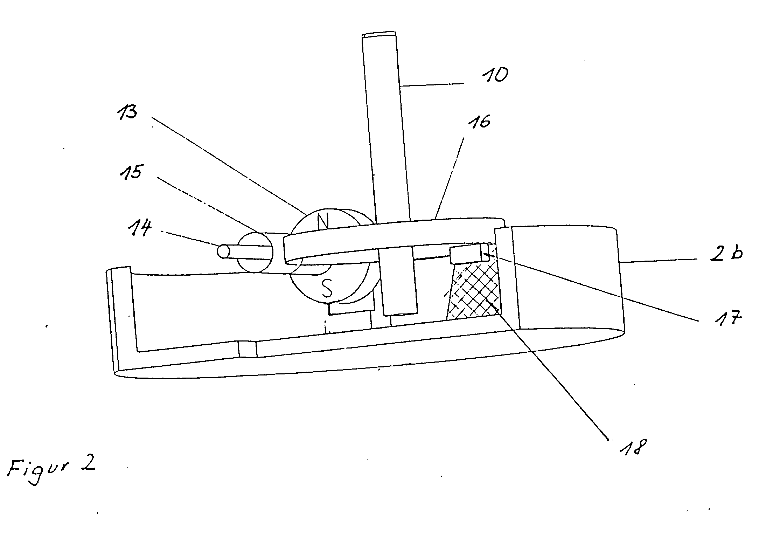

In Figur 2 ist die Lagerung des Rotorsystems des Schrittmotors in der Gehäusehälfte 2b des Meßwerkes dargestellt.

Ein als Rotor 13 arbeitender, zwei Pole N, S aufweisender Magnet ist fest auf einer Rotorwelle 14 angeordnet, welche einen Schneckentrieb 15 trägt, wobei der Schneckentrieb 15 ebenfalls fest mit der Rotorwelle 14 verbunden ist. Der Schneckentrieb 15 greift in ein auf der Zeigerwelle 10 befestigtes Stirnrad 16, welches einen Anschlag 17 aufweist. Ein Gegenanschlag 18 ist an der Innenseite seite der Gehäusehälfte 2b angebracht, in der Art, daß in der Ruhestellung des Rotors 13 der Anschlag 17 und der Gegenanschlag 18 sich berühren und somit der Nullpunkt des Zeigers eindeutig mechanisch fixiert ist.

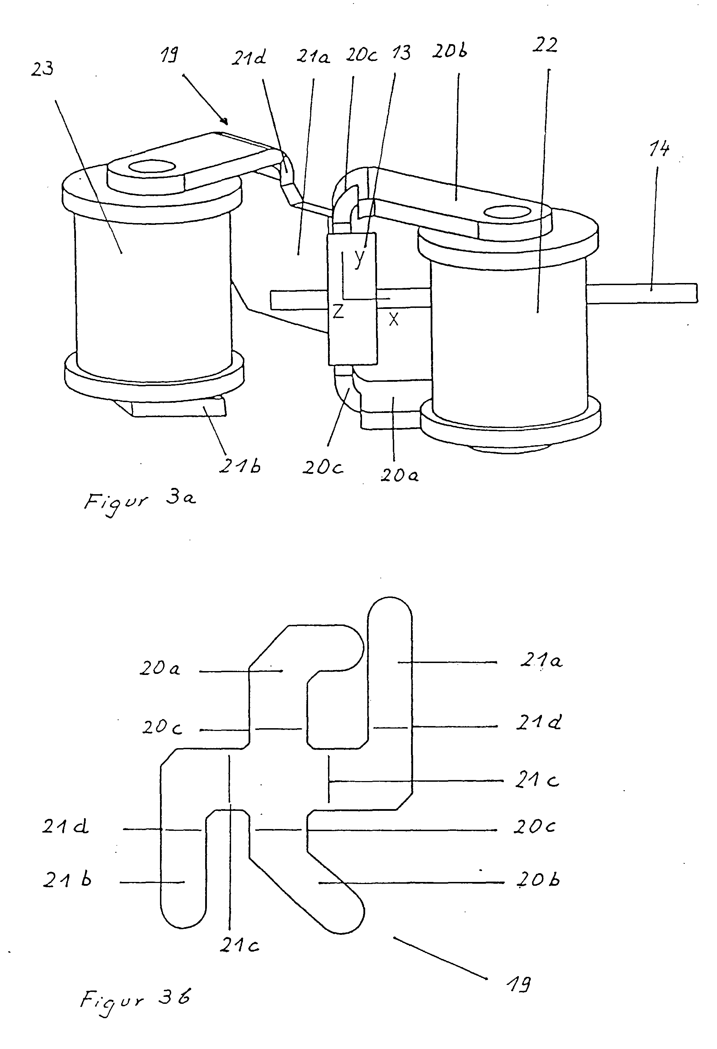

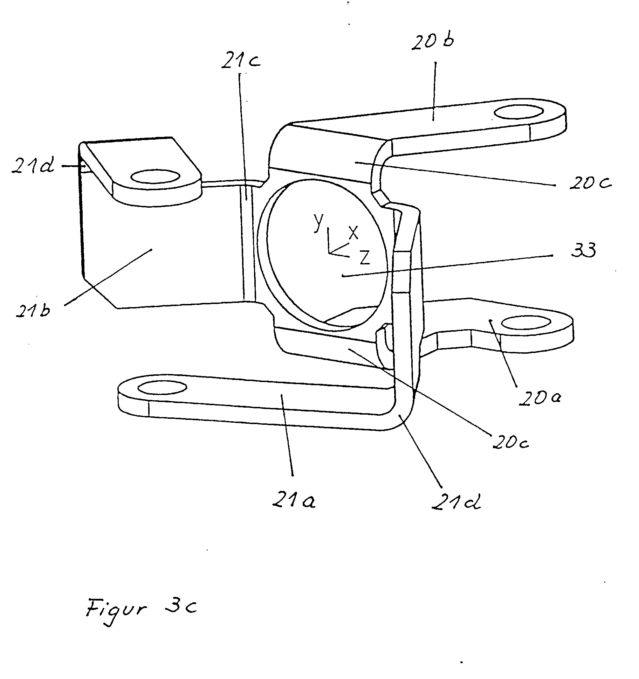

Gemäß der Darstellung in Figur 3a ist der auf der Rotorwelle 14 befindliche Rotor 13 im Eisenkreis 19 eines Stators angeordnet, wobei die Rotorwelle 14 durch eine Statoröffnung 33 geführt ist (Fig. 3c).

Der Rotor 13 ist dabei so auf der Rotorwelle 14 angeordnet, daß er nichtfluchtend zum Eisenkreis 19 befestigt ist. Hierdurch entsteht eine Kraftkomponente in Richtung Rotorachse 14, welche bewirkt, daß die Welle immer einseitig in einer Lagerung anliegt.

Der Stator besteht, wie in Figur 3a gezeigt, aus einem einstückigen Eisenkreis 19, durch welchen die Führung des magnetischen Flusses zur Erregung des Systems erfolgt, sowie den Erregerwicklungen 22, 23.

Der Eisenkreis 19 ist eine 4armige Anordnung, bei welcher zwei gegenüberliegende Arme 20a und 20b ein Armpaar 20 und die Arme 21a und 21b ein Armpaar 21 bilden. Die Arme der Armpaare sind unterschiedlich lang ausgebildet.

Zur Vereinfachung der Beschreibung der Anordnung wurde in Fig. 3a und c ein dreidimensionales Koordinatensystem angedeutet.

Die Arme 20a und 20b sind in derselben Ebene (Fig. 3b) um unterschiedliche Winkel gekrümmt. Sie werden entlang der Linien 20c in x-Richtung um jeweils 90° zueinander gebogen, wie es in Figur 3c dargestellt ist. Die Arme 20a und 20b sind dabei in x-Richtung parallel zueinander ausgerichtet.

Die Arme 21a und 21b des zweiten Armpaares 21 sind mehrfach gegeneinander gebogen.

Entlang der Linien 21c sind die Arme 21a bzw. 21b um 90° ebenfalls zueinander, aber in entgegengesetzter Richtung zu den Armen 20a bzw. 20b des Armpaares 20 gekröpft (aus y-Richtung in x-Richtung). In einem weiteren Biegevorgang um die Linie 21d werden die freien Enden der Arme 21a,b ebenfalls um 90° zueinander gebogen (z-Richtung).

Zwischen den Armen 20a und 20b ist eine erste Erregerwicklung 22 und zwischen den Armen 21a und 21b eine zweite Erregerwicklung 23 angeordnet.

Das dreidimensionale Stanz-/Biegeteil hat somit eine Form, daß sich die zur Ansteuerung erforderlichen, orthogonal zueinander angeordneten magnetischen Kraftvektoren ergeben. Die beiden Erregerwicklungen sind dabei in derselben axialen Richtung angeordnet.

Zur Erregung des Magnetkreises wird den Erregerwicklungen 22, 23 elektrische Energie zugeführt. Die beiden erregenden magnetischen Vektoren bilden eine Resultierende, wonach sich der Rotor 13 ausrichtet. Die Winkeländerung des Rotors 13 wird mittels der Rotorwelle 14 auf das Zeiger-Antriebssystem übertragen. Dies erfolgt über den fest auf der Rotorwelle angeordneten Schneckentrieb 15, der in das Stirnrad 16 eingreift. Da das Stirnrad 16 fest auf der Zeigerwelle 10 angeordnet ist, dreht sich die Zeigerwelle 10 entsprechend der Winkeländerung des Rotors 13. Die Winkeländerung wird durch einen mit der Zeigerwelle 10 verbundenen Zeiger zur Anzeige gebracht.

Zur Erregung des Magnetkreises werden den Erregerwicklungen 22, 23 Stromimpulse über die Leitbahnen einer Leiterplatte zugeführt, die auch als flexible Leiterfolie oder ein Verbundleitersystem gestaltet sein kann.

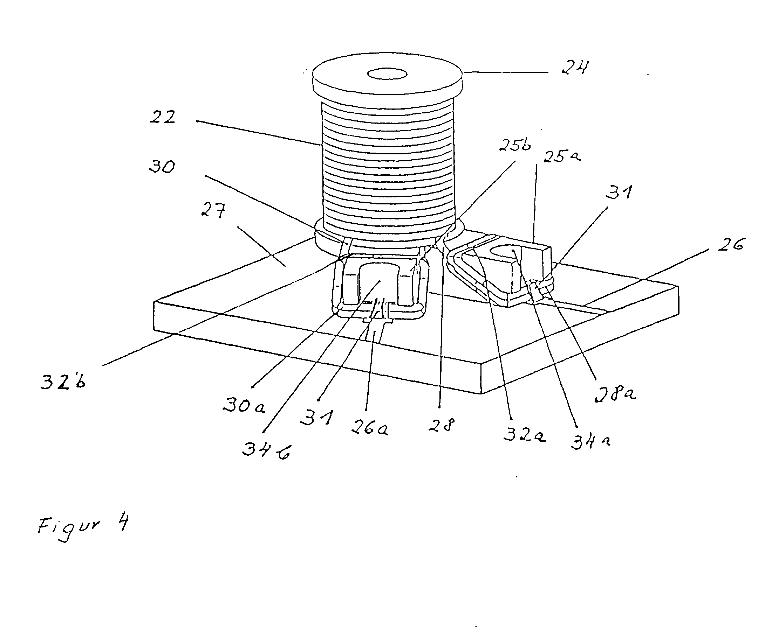

Die prinzipielle Kontaktierung einer Erregerwicklung 22 ist in Figur 4 dargestellt.

Dieser Wickelkörper 24 weist zwei elektrisch isolierende Kontaktfüße 25a und 25b auf, die in einer Ebene an einem Ende des Wickelkörpers 24 parallel zur Erregerwicklung 22 befestigt sind. Die Kontaktfüße 25a und 25b weisen dabei einen identischen Aufbau auf. Sie sind so gabelförmig gestaltet, daß sie in der zum Wickelkörper 24 entgegengesetzten Richtung eine Ausnehmung 34a, 34b haben, die zur Leitbahn 26, 26a der Leiterplatte 27 offen ist.

Unterhalb des gabelförmigen Kontaktfusses ist eine Führung in Form einer Nut für die um den Kontaktfuß geführten Windungen 28a, 30a des Wicklungsendes 28, 30 vorgesehen. In Richtung der Erregerwicklung 22 zwischen Wickelkörper 24 und der Ausnehmung 34a, 34b weisen die Kontaktfüße 25a und 25b jeweils eine Aussparung 32a bzw. 32b zur Fixierung der Windungen 28a und 30a am jeweiligen Kontaktfuß auf.

Herstellungsmäßig wird ein erstes Ende 28 der Erregerwicklung 22 mehrfach um den ersten Kontaktfuß 25a gewickelt, so daß die Windungen 28a die Leitbahn 26 berühren.

Nach Umwicklung des ersten Kontaktfusses 25a wird der Wickelkörper 24 mit der Spulenwicklung 22 versehen. Danach wird der zweite Kontaktfuß 25b in der gleichen Art und Weise wie der erste Kontaktfuß 25a mit dem zweiten Spulenende 30 umwickelt.

Zur Kontaktierung werden die Kontaktfüße 25a und 25b auf der Leiterplatte 27 aufgesetzt und sind elektrisch mit der Leitbahn 26, 26a der Leiterplatte 27 verbunden. Die Wicklungsenden 28a berühren dabei die Leitbahn 26 und die Wicklungsenden 30a die Leitbahn 26a.

Die Kontaktierung der Windungen 28a und 30a der beiden Spulenenden 28 bzw. 30 erfolgt über eine Lötverbindung 31,

Die gabelförmige Ausführung ermöglicht die Ansammlung von Kontaktpaste, im vorliegenden Fall Lötpaste, und gewährleistet somit eine zuverlässige Kontaktierung der Leitbahnen mit den Wicklungsenden.

Neben einem automatischen Lötvorgang kann die Kontaktierung aber auch durch Leitkleben erfolgen.

## Patentansprüche

1. Elektromotor, welcher zwei voneinander unabhängige Erregerwicklungen auf einem Stator aufweist, mit welchen ein Magnetfeld erzeugbar ist sowie einen mindestens ein Polpaar besitzenden, permanent magnetisierten Rotor, welcher seine Positon in Abhängigkeit vom Magnetfeld ändert, wobei der Rotor fest axial auf einer Rotorwelle angeordnet ist, wobei der Stator (19) eine mehrarmige Anordnung aufweist, welche zentrisch eine Öffnung (33) zur Positionierung der den Rotor (13) tragenden Rotorwelle (14) aufweist, wobei die einzelnen Arme (20a,b; 21a,b) um die Öffnung (33) herum angeordnet sind und jeweils zwei gegenüberliegende Arme (20a,b; 21a,b) ein Armpaar (20, 21) bilden, wobei die gegenüberliegenden Arme (20a,b; 21a,b) so zueinander gebogen sind, daß sie bei Aufnahme jeweils einer Erregerwicklung (22, 23) orthogonal zueinander angeordnete magnetische Kraftvektoren erzeugen, und wobei zwei gegenüberliegende Arme (20a,b) eines Armpaares (20) einfach zueinander gekröpft sind, so daß die Arme (20a,b) parallel zueinander ausgerichtet sind, **dadurch gekennzeichnet,** daß zwei gegenüberliegende Arme (21a,b) eines Armpaares (21) mehrfach zueinander gekröpft sind.

2. Elektromotor nach Anspruch 1, **dadurch gekennzeichnet,** daß vier Arme (20a,b; 21a,b) im 90°-Abstand um die Öffnung (33) angeordnet sind.

3. Elektromotor nach Anspruch 1 oder 2, **dadurch gekennzeichnet,** daß die Arme (21a,b) in Öffnungsnähe eine erste (21c) und in Nähe der freien Enden jedes Armes (21a,b) eine zweite Kröpfung (21d) aufweisen.

4. Elektromotor nach einem der Ansprüche 1 bis 3, **dadurch gekennzeichnet**, daß der Abstand der freien Enden der gegeneinander gebogenen Arme (20a,b; 21a,b) der Armpaare (20, 21) so gewählt ist, daß jeweils eine Erregerwicklung (22, 23) kraftschlüssig zwischen diesen lagerbar ist.

5. Elektromotor nach einem der Ansprüche 1 bis 3, **dadurch gekennzeichnet,** daß die freien Enden der gegeneinander gebogenen Arme (20a,b; 21a,b) der Armpaare (20, 21) Bohrungen zur Befestigung der Erregerwicklungen (22, 23) aufweisen.

6. Elektromotor nach einem der vorhergehenden Ansprüche, **dadurch gekennzeichnet,** daß die einzelnen Arme (20a,b; 21a,b) unterschiedliche Längen aufweisen.

7. Elektromotor nach einem der vorhergehenden Ansprüche, **dadurch gekennzeichnet,** daß der Stator (19) ein einstückiges Stanz-/Biegeteil ist.

8. Elektromotor nach Anspruch 1, **dadurch gekennzeichnet,** daß der Rotor (13) nicht fluchtend zum Stator (19) angeordnet ist.

9. Meßwerk mit einem Elektromotor nach Anspruch 1, **dadurch gekennzeichnet,** daß der Elektromotor und ein Zeigerantriebssystem in einem Gehäuse angeordnet sind, daß zwischen Elektromotor und Zeigerantriebssystem ein Getriebe (15, 16) zur Übertragung der jeweiligen Rotorposition an das Zeigerantriebssystem zwischen Rotorwelle (14) und einer Zeigerwelle (10) geschaltet ist und sowohl am Gehäuse (2) als auch an einem auf der Zeigerwelle (10) positionierten Stirnrad (16) des Getriebes (15, 16) ein Anschlag (17, 18) zur mechanischen Einstellung des Nullpunktes des Zeigerantriebssystem angeordnet ist.

10. Meßwerk nach Anspruch 9, **dadurch gekennzeichnet,** daß das Gehäuse (2) zylinderförmig gestaltet ist.

11. Meßwerk nach Anspruch 10, **dadurch gekennzeichnet**, daß an mindestens einer kreisförmigen Gehäuseoberfläche (2d) des zylinderförmigen Gehäuses (2) mindestens ein Rastzapfen (3b) zur Befestigung an einem Trägerkörper angeordnet ist.

12. Meßwerk nach Anspruch 11, **dadurch gekennzeichnet,** daß der Trägerkörper eine Leiterplatte ist.

13. Meßwerk nach Anspruch 10 und 11, **dadurch gekennzeichnet,** daß an der entgegengesetzten Gehäusefläche (2c) ebenfalls mindestens ein Rastzapfen (3a) zur Verbindung mit einem Adapter (4) angebracht ist.

14. Meßwerk nach Anspruch 13, **dadurch gekennzeichnet**, daß der Adapter (4) neben mindestens einer rastenden Aufnehmung (5) für den Rastzapfen (3a) Öffnungen (11) zur Realisierung einer Schraubverbindung mit einem Zifferblatt aufweist.

15. Meßwerk nach einem der Ansprüche 9 bis 14, **dadurch gekennzeichnet,** daß das Gehäuse (2) aus zwei identischen Hälften (2a, 2b) besteht.

## Claims

1. Electric motor which has two exciter windings, independent of each other, on a stator, by which windings a magnetic field can be produced, and has a permanently magnetized rotor which has at least one pair of poles and changes its position as a function of the magnetic field, the rotor being arranged in an axially fixed manner on a rotor shaft, the stator (19) having a multi-arm arrangement which has at the centre an opening (33) for the positioning of the rotor shaft (14) bearing the rotor (13), the individual arms (20a,b; 21a,b) being arranged around the opening (33) and every two arms (20a,b; 21a,b) lying opposite each other respectively forming a pair of arms (20, 21), the opposite arms (20a,b; 21a,b) being bent towards each other such that, on receiving a respective exciter winding (22, 23), they produce magnetic force vectors arranged perpendicular to one another, and two opposite arms (20a,b) of a pair of arms (20) being singly offset with respect to each other, so that the arms (20a,b) are aligned parallel to each other, characterized in that the two opposite arms (21a,b) of a pair of arms (21) are multiply offset with respect to each other.

2. Electric motor according to Claim 1, characterized in that four arms (20a,b; 21a,b) are arranged at 90° intervals around the opening (33).

3. Electric motor according to Claim 1 or 2, characterized in that the arms (21a,b) have a first offset (21c) in the vicinity of the opening and a second offset (21d) in the vicinity of the free end of each arm (21a,b).

4. Electric motor according to one of Claims 1 to 3, characterized in that the distance between the free ends of the arms (20a,b; 21a,b), bent towards each other, of the pairs of arms (20, 21) is chosen such that in each case an exciter winding (22, 23) can be mounted with frictional engagement between these arms.

5. Electric motor according to one of Claims 1 to 3, characterized in that the free ends of the arms (20a,b; 21a,b), bent towards each other, of the pairs of arms (20, 21) have bores for the fastening of the exciter windings (22, 23).

6. Electric motor according to one of the preceding claims, characterized in that the individual arms (20a,b; 21a,b) have different lengths.

7. Electric motor according to one of the preceding claims, characterized in that the stator (19) is a one-piece stamped/bent part.

8. Electric motor according to Claim 1, characterized in that the rotor (13) is not arranged in line with the stator (19).

9. Measuring device with an electric motor according to Claim 1, characterized in that the electric motor and a pointer drive system are arranged in a housing, in that between the electric motor and the pointer drive system a gear mechanism (15, 16) for transmitting the respective rotor position to the pointer drive system is connected between the rotor shaft (14) and a pointer shaft (10) and, arranged both on the housing (2) and on a spur wheel (16) of the gear mechanism (15, 16) positioned on the pointer shaft (10), there is a stop (17, 18) for the mechanical setting of the zero point of the pointer drive system.

10. Measuring device according to Claim 9, characterized in that the housing (2) is cylindrically shaped.

11. Measuring device according to Claim 10, characterized in that, arranged on at least one circular housing surface (2d) of the cylindrical housing (2), there is at least one latching pin (3b) for fastening to a supporting element.

12. Measuring device according to Claim 11, characterized in that the supporting element is a printed-circuit board.

13. Measuring device according to Claims 10 and 11, characterized in that, attached on the opposite housing surface (2c), there is likewise at least one latching pin (3a) for connection to an adapter (4).

14. Measuring device according to Claim 13, characterized in that, in addition to at least one latching recess (5) for the latching pin (3a), the adapter (4) has openings (11) for realizing a screw connection with a dial.

15. Measuring device according to one of Claims 9 to 14, characterized in that the housing (2) comprises two identical halves (2a, 2b).

## Revendications

1. Moteur électrique, présentant deux bobinages d'excitation indépendants l'un de l'autre sur un stator, permettant de générer un champ magnétique, et un rotor à aimantation permanente, possédant au moins une paire de pôles, qui modifie sa position en fonction du champ magnétique, le rotor étant fixé axialement sur un arbre de rotor, le stator (19) présentant un arrangement à plusieurs bras, qui présente au centre une ouverture (33) pour le positionnement de l'arbre de rotor (14) portant le rotor (13), les bras individuels (20a,b; 21a,b) étant disposés autour de l'ouverture (33) et deux bras opposés (20a,b; 21a,b) formant à chaque fois une paire de bras (20, 21), les bras opposés (20a,b; 21a,b) étant courbés l'un par rapport à l'autre de telle sorte qu'il génèrent des vecteurs de force magnétique orthogonaux lors de la réception à chaque fois d'un bobinage d'excitation (22, 23), et deux bras opposés (20a,b) d'une paire de bras (20) étant coudés simplement l'un par rapport à l'autre de sorte que les bras (20a,b) soient orientés parallèlement l'un à l'autre, **caractérisé en ce que** deux bras opposés (21a,b) d'une paire de bras (21) sont coudés plusieurs fois l'un par rapport à l'autre.

2. Moteur électrique selon la revendication 1, **caractérisé en ce que** quatre bras (20a,b; 21a,b) sont disposés à un écartement de 90° autour de l'ouverture (33).

3. Moteur électrique selon la revendication 1 ou 2, **caractérisé en ce que** les bras (21a,b) présentent un premier coude (21c) à proximité de l'ouverture et un deuxième coude (21d) à proximité de l'extrémité libre de chaque bras (21a,b).

4. Moteur électrique selon l'une quelconque des revendications 1 à 3, **caractérisé en ce que** l'écartement des extrémités libres des bras courbés l'un par rapport à l'autre (20a,b; 21a,b) des paires de bras (20, 21) est choisi de telle sorte que l'on puisse monter à chaque fois un bobinage d'excitation (22, 23) à engagement par force entre ceux-ci.

5. Moteur électrique selon l'une quelconque des revendications 1 à 3, **caractérisé en ce que** les extrémités libres des bras courbés l'un par rapport à l'autre (20a,b; 21a,b) des paires de bras (20, 21) présentent des alésages pour la fixation des bobinages d'excitation (22, 23).

6. Moteur électrique selon l'une quelconque des revendications précédentes, **caractérisé en ce que** les bras individuels (20a,b; 21a,b) présentent des longueurs différentes.

7. Moteur électrique selon l'une quelconque des revendications précédentes, **caractérisé en ce que** le stator (19) est une pièce estampée/cintrée d'une seule pièce.

8. Moteur électrique selon la revendication 1, **caractérisé en ce que** le rotor (13) n'est pas disposé en alignement par rapport au stator (19).

9. Appareil de mesure comprenant un moteur électrique selon la revendication 1, **caractérisé en ce que** le moteur électrique et un système d'entraînement d'aiguille sont disposés dans un boîtier, en ce qu'entre le moteur électrique et le système d'entraînement d'aiguille est monté un engrenage (15, 16) pour la transmission de la position respective du rotor au système d'entraînement d'aiguille entre l'arbre du rotor (14) et un arbre d'aiguille (10) et une butée (17, 18) pour l'ajustement mécanique du point zéro du système d'entraînement d'aiguille est disposée à la fois sur le boîtier (2) et sur un pignon droit (16) de l'engrenage (15, 16) positionné sur l'arbre d'aiguille (10).

10. Appareil de mesure selon la revendication 9, **caractérisé en ce que** le boîtier (2) a une forme cylindrique.

11. Appareil de mesure selon la revendication 10, **caractérisé en ce que** sur au moins une surface circulaire (2d) du boîtier cylindrique (2) est disposé au moins un tourillon d'enclenchement (3b) destiné à la fixation sur un corps de support.

12. Appareil de mesure selon la revendication 11, **caractérisé en ce que** le corps de support est une plaquette de circuits imprimés.

13. Appareil de mesure selon la revendication 10 ou 11, **caractérisé en ce qu'**au moins un tourillon d'enclenchement (3a) pour la connexion à un adaptateur (4) est également monté sur la face opposée (2c) du boîtier.

14. Appareil de mesure selon la revendication 13, **caractérisé en ce que** l'adaptateur (4) présente, en plus d'un logement d'enclenchement (5) pour le tourillon d'enclenchement (3a), des ouvertures (11) pour réaliser une connexion vissée avec un cadran.

15. Appareil de mesure selon l'une quelconque des revendications 9 à 14, **caractérisé en ce que** le boîtier (2) se compose de deux moitiés identiques (2a, 2b).
